# EUROPEAN PATENT APPLICATION

(11) **EP 3 716 458 A1**
(43) Date of publication of application: **30.09.2020**
(21) Application number: 20164656.9
(22) Date of filing: 20.03.2020
(51) Int. Cl.: H02M 1/32, H02M 3/156, H02H 7/122, H03K 17/082

(54) **PROCESSING CIRCUIT AND POWER SUPPLY DEVICE**

(30) Priority: 29.03.2019 JP 2019067597
(71) Applicant: TDK Corporation, Tokyo 103-6128 (JP)
(72) Inventor: HARIYA, Akinori, Tokyo 103-6128 (JP); NEGORO, Kenji, Tokyo 103-6128 (JP)
(74) Representative: Epping - Hermann - Fischer

(57) **Abstract**

What is provided is a processing circuit capable of preventing a high voltage from being applied to a main circuit at the time of a sudden voltage change.

A processing circuit includes a differentiation circuit configured to output a differential value of a change in a target voltage, a predetermined voltage output unit configured to output a predetermined voltage when the differential value output from the differentiation circuit is equal to or greater than a predetermined value, and a predetermined processing executor configured to execute predetermined processing based on a voltage output from the predetermined voltage output unit on a protection circuit having a function of performing protection on the basis of a current detected by a current detector.

## Description

### BACKGROUND OF THE INVENTION

### Field of the Invention

The present invention relates to a processing circuit and a power supply device.

Priority is claimed on Japanese Patent Application No. 2019-067597, filed March 29, 2019, the content of which is incorporated herein by reference.

### Description of Related Art

A switching power supply device that converts input direct current or alternating current power into a direct current power is known (refer to Patent Document 1).

In the switching power supply device, a high voltage associated with a fast rise of a voltage may be applied to a circuit at the time of a sudden change in an input source voltage. In this case, conventionally, overvoltage protection in a level detection method has been performed.

### [Patent Documents]

[Patent Document 1] Japanese Unexamined Patent Application, First Publication No. 2005-73430

### SUMMARY OF THE INVENTION

In a switching power supply device, in overvoltage protection of an existing level detection method, protection is not sufficient and a high voltage is added to a semiconductor switching element in excess of a withstand voltage of the semiconductor switching element, and the element may break in some cases.

The present invention has been made in consideration of such circumstances, and an object thereof is to provide a processing circuit and a power supply device which can prevent a high voltage from being applied at the time of a sudden voltage change.

According to one aspect of the present invention, a processing circuit includes a differentiation circuit configured to output a differential value of a change in a target voltage, a predetermined voltage output unit configured to output a predetermined voltage when the differential value output from the differentiation circuit is equal to or greater than a predetermined value, and a predetermined processing executor configured to execute predetermined processing based on a voltage output from the predetermined voltage output unit on a protection circuit having a function of performing protection on the basis of a current detected by a current detector.

According to the present invention, the processing circuit and the power supply device can prevent a high voltage from being applied to a main circuit (for example, a semiconductor switching element) at the time of a sudden voltage change.

### BRIEF DESCRIPTION OF THE DRAWINGS

FIG. 1 is a diagram which shows a schematic configuration of a power supply device according to an embodiment of the present invention.
FIG. 2 is a diagram which shows an example of a signal waveform in an input voltage and an operation circuit at the time of detection of a sudden voltage change according to the embodiment of the present invention.

### DETAILED DESCRIPTION OF THE INVENTION

Hereinafter, an embodiment of the present invention will be described with reference to the drawings.

### [Power supply device]

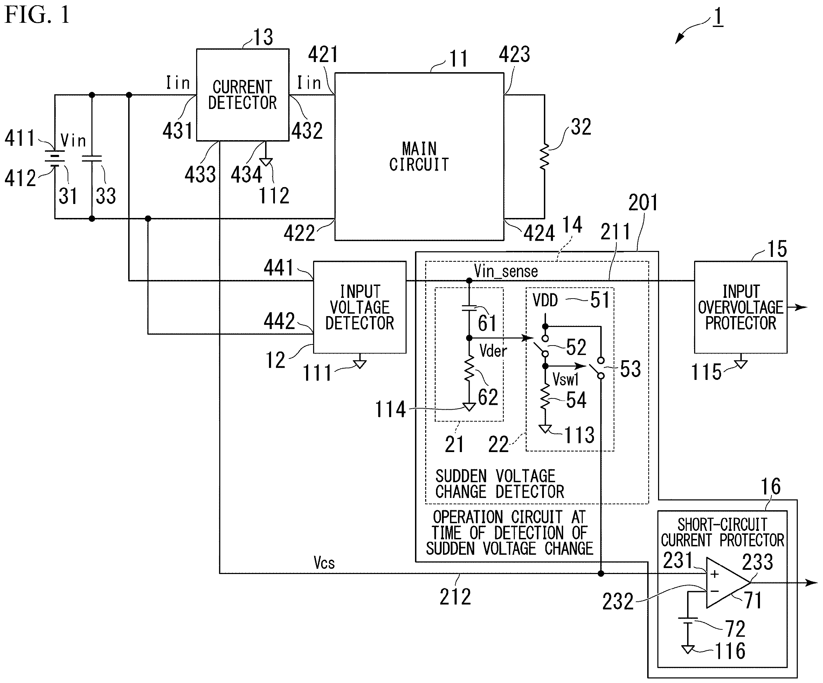

FIG. 1 is a diagram which shows a schematic configuration of a power supply device 1 according to an embodiment of the present invention.

In the present embodiment, the power supply device 1 is a switching power supply device.

The power supply device 1 includes a main circuit 11, an input voltage detector 12, a current detector 13, a sudden voltage change detector 14, an input overvoltage protector 15, a short-circuit current protector 16, an input power supply 31, a load 32, and an input capacitor 33.

Here, for example, a conventionally known circuit configuration may be used for the main circuit 11 which supplies power to the load 32, the input voltage detector 12 which detects an input voltage, the current detector 13 which detects a current, the input overvoltage protector 15 which protects from an input overvoltage, and the short-circuit current protector 16. In the present embodiment, a detailed circuit configuration will not be described. However, since the short-circuit current protector 16 is related to an operation of the embodiment, the circuit configuration and the operation will be described.

The sudden voltage change detector 14 includes a differentiation circuit 21 and a predetermined voltage output unit 22.

The differentiation circuit 21 includes a capacitor 61, a resistor 62, and a ground end 114.

The predetermined voltage output unit 22 includes an auxiliary power supply 51, a switch 52, a switch 53, a resistor 54, and a ground end 113.

The short-circuit current protector 16 includes a comparator 71, a reference power supply 72, and a ground end 116.

In the present embodiment, an operation circuit at the time of detection of a sudden voltage change 201 is configured from the sudden voltage change detector 14 and the short-circuit current protector 16. The operation circuit at the time of detection of a sudden voltage change 201 is a circuit that performs a predetermined operation (predetermined processing) when a sudden change in a target voltage is detected.

### <Connection relationship of circuit>

Here, the input power supply 31, the current detector 13, and the main circuit 11 are connected in series. The main circuit 11 and the load 32 are connected.

The input voltage detector 12 is connected to the input power supply 31.

Each of the input voltage detector 12 and the current detector 13 is connected to the sudden voltage change detector 14.

The sudden voltage change detector 14 is connected to each of the input overvoltage protector 15 and the short-circuit current protector 16.

In the sudden voltage change detector 14, a connecting line 211 that connects the input voltage detector 12 and the input overvoltage protector 15 is provided, and the differentiation circuit 21 is connected to the connecting line 211. In the differentiation circuit 21, the capacitor 61 and the resistor 62 are connected in series to the connecting line 211, and the ground end 114 is connected to a tip of this resistor 62.

In the sudden voltage change detector 14, a connecting line 212 that connects the current detector 13 and the short-circuit current protector 16 is provided, and the switch 53 is connected between the connecting line 212 and the auxiliary power supply 51. In addition, the switch 52 and the resistor 54 are connected in series to the auxiliary power supply 51, and the ground end 113 is connected to a tip of this resistor 54. Note that the switch 52 and the switch 53 are connected in parallel to the auxiliary power supply 51.

Here, the connection relationship described above will be described in more detail.

The input power supply 31 is a direct current voltage source having two output terminals 411 and 412 of a positive electrode terminal (a terminal on a high voltage side) and a negative electrode terminal (a terminal on a low voltage side).

The main circuit 11 has two input terminals 421 and 422 for receiving power from the input power supply 31 and two output terminals 423 and 424 for providing power to the load 32.

Two terminals 441 and 442 of the input voltage detector 12 and an input capacitor 33 which is generally provided are connected between the two output terminals 411 and 412 of the input power supply 31.

The current detector 13 has an inflow terminal 431 and an outflow terminal 432 of a current, and two output terminals 433 and 434 for outputting a detection result of a detected current signal to detect a current Iin (a current flowing through the main circuit 11) associated with supply of power from the input power supply 31 to the main circuit 11 via the input capacitor 33, and the inflow terminal 431 and the outflow terminal 432 of the current detector 13 and the input terminal 421 and the input terminal 422 of the main circuit 11 are connected in series between the two output terminals 411 and 412 of the input power supply 31 (and between both ends of the input capacitor 33).

Therefore, the current detector 13 may be inserted into a high voltage line on a side of the output terminal 411 of the input power supply 31, or may be inserted into a low voltage line on a side of the output terminal 412.

As in the example of FIG. 1, when the current detector 13 is inserted into the high voltage line, the input capacitor 33 and the input voltage detector 12 are connected to a side of the inflow terminal 431 of the current detector 13. As another example, when the current detector 13 is inserted into the low voltage line, the input capacitor 33 and the input voltage detector 12 are connected to a side of the outflow terminal 432 of the current detector 13.

A detection value of a voltage of the input power supply 31 on a primary side detected by the input voltage detector 12 is converted by an insulation transformer and the like, and is transmitted to the sudden voltage change detector 14 on a secondary side and the input overvoltage protector 15.

A result of detecting, by the sudden voltage change detector 14, a sudden change in power supply of the input power supply 31 is transmitted to the short-circuit current protector 16.

A detection value of the input current Iin on the primary side, detected by the current detector 13, is converted into a voltage by a current transformer or the like, and is transmitted to the short-circuit current protector 16 on the secondary side.

Here, in the present embodiment, respective elements connected to each other are, for example, connected via a connecting line, but for convenience of description, reference numerals and a detailed description of connecting lines other than some connecting lines 211 and 212 will be omitted.

In the short-circuit current protector 16, the connecting line 212 is connected to the positive input terminal 231 of the comparator 71, and an output end of the current detector 13 and one end of the switch 53 are connected in parallel via the connecting line 212.

A reference power supply 72 is connected between a negative input terminal 232 of the comparator 71 and the ground end 116. A positive-side terminal of the reference power supply 72 is connected to the negative input terminal 232 of the comparator 71, and a negative-side terminal of the reference power supply 72 is connected to the ground end 116.

Here, in the present embodiment, a ground end 111 of the input voltage detector 12, a ground end 112 of the current detector 13, ground ends 113 and 114 of the sudden voltage change detector 14, a ground end 115 of the input overvoltage protector 15, and a ground end 116 of the short-circuit current protector 16 are connected to a common ground.

### <Example of operation of circuit>

The input power supply 31 outputs a predetermined voltage Vin to the main circuit 11.

The main circuit 11 generates power using the voltage Vin input from the input power supply 31, and supplies the power to the load 32.

The load 32 performs an operation using the power supplied from the main circuit 11. Note that any load may be used as the load 32.

The input voltage detector 12 detects the voltage Vin input from the input power supply 31 to the main circuit 11, and outputs the detected voltage Vin_sense to the sudden voltage change detector 14.

Here, the input voltage detector 12 detects, for example, the voltage Vin using a transformer and generates the voltage Vin_sense via the transformer.

In the present embodiment, the voltage Vin_sense output from the input voltage detector 12 is a voltage having a waveform such as a rectangular shape of an alternating current at the time of a sudden change in input voltage. In this case, for example, a rectifying element that performs rectification to apply a voltage from the differentiation circuit 21 to a control end of the switch 52 may be provided between the differentiation circuit 21 and the switch 52. As the rectifying element, for example, a diode may also be used.

The current detector 13 detects the current Iin flowing between the input power supply 31 and the main circuit 11, and inputs a voltage Vcs in accordance with the detected current Iin to a positive input terminal 231 of the short-circuit current protector 16. Accordingly, when a short-circuit current has flowed through the main circuit 11, a value of the positive input terminal 231 of the short-circuit current protector 16 exceeds a voltage (reference voltage) Vref of the reference power supply 72, and switching of the main circuit 11 stops.

The voltage Vin_sense detected by the input voltage detector 12 is input to the input overvoltage protector 15 via the connecting line 211. Then, the input overvoltage protector 15 performs control to stop the switching of the main circuit 11 when the input voltage Vin sense is an overvoltage. Here, a condition for determining whether there is an overvoltage is, for example, set in the input overvoltage protector 15 in advance.

An operation performed in the sudden voltage change detector 14 will be described.

The differentiation circuit 21 outputs a voltage Vder corresponding to a result (a derived function and a slope) obtained by differentiating the voltage Vin_sense input from the input voltage detector 12 to the control end of the switch 52. In the present embodiment, the switch 52 is turned on (a conducted state) when the voltage Vder is equal to or higher than a predetermined threshold value, and the switch 52 is turned off (a non-conducted state) when the voltage Vder is less than the predetermined threshold value.

If the switch 52 is turned on, a voltage VDD output from the auxiliary power supply 51 is applied to the resistor 54, and a voltage Vsw1 applied to the resistor 54 is output to a control end of the switch SW2. In the present embodiment, the switch 53 is turned on (the conducted state) when the voltage Vsw1 is equal to or higher than the predetermined threshold value, and the switch 53 is turned off (the non-conducted state) when the voltage Vsw1 is less than the predetermined threshold value.

If the switch 53 is turned on, a voltage VDD output from the auxiliary power supply 51 is applied through the switch 53, and the voltage VDD is applied to the short-circuit current protector 16.

Here, each of the switches 52 and 53 may be configured using, for example, a field effect transistor (FET) or a bipolar transistor.

In addition, each of the switches 52 and 53 may have, for example, a multi-stage configuration.

An operation performed in the short-circuit current protector 16 will be described.

In the comparator 71, the voltage VDD output from the sudden voltage change detector 14 is input to the positive input terminal 231, and a reference voltage (reference voltage) Vref output from the reference power supply 72 is input to the negative input terminal 232.

Then, the comparator 71 performs control to cause switching of the main circuit 11 to stop when the voltage VDD input from the sudden voltage change detector 14 exceeds the reference voltage Vref. As a specific example, in a configuration in which an output voltage from the output terminal 233 of the comparator 71 is input to an enable terminal of an integrated circuit (IC) for power supply control, when the voltage VDD input from the sudden voltage change detector 14 exceeds the reference voltage Vref, the comparator 71 may cause the switching of the main circuit 11 to stop by inputting an enable signal to the enable terminal of the IC for power supply control.

Here, in the present embodiment, the voltage VDD is set to a value larger than the reference voltage Vref.

In addition, the reference voltage Vref is a voltage corresponding to a threshold for protecting from a short-circuit current of the main circuit 11.

### [Example of signal waveform]

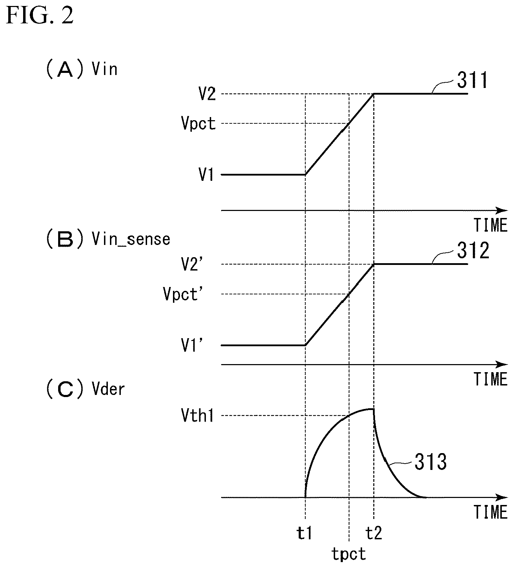

FIG. 2 is a diagram which shows examples of signal waveforms in the input voltage and the operation circuit at the time of detection of a sudden voltage change 201 according to the embodiment of the present invention.

In FIGS. 2(A), 2(B), and 2(C), horizontal axes represent time in common and vertical axes represent a value of each voltage.

FIG. 2(A) shows an example of a waveform 311 of the voltage Vin output from the input power supply 31.

FIG. 2(B) shows an example of a waveform 312 of the voltage Vin_sense detected by the input voltage detector 12.

FIG. 2(C) shows an example of a waveform 313 of the voltage Vder output from the differentiation circuit 21 to the control end of the switch 52.

If the input voltage Vin changes steeply from a voltage V1 at a time t1 to a voltage V2 at a time t2, the output voltage Vin_sense from the input voltage detector 12 also changes steeply from a voltage VI' to a voltage V2' in the same manner. As a result, the output voltage Vder from the differentiation circuit 21 reaches a threshold voltage Vth1 for switching the switch 52 from OFF to ON and the switch 52 is switched from OFF to ON.

If the switch 52 is turned on, the voltage VDD is applied to an output voltage from the switch 52, and the switch 53 is switched from OFF to ON. If the switch 53 is turned on, the voltage VDD is applied to the short-circuit current protector 16. The voltage VDD is set to be higher than the reference voltage Vref of the short-circuit current protector 16. As a result, the comparator 71 outputs a high signal, and the main circuit 11 stops switching.

Here, in the example of FIG. 2(C), the voltage Vder reaches the voltage Vth1 at a time tpct.

In the example of FIG. 2(A), a value Vpct of the input voltage Vin at the time tpct is shown.

FIG. 2(B) shows a value Vpct' of the voltage Vin_sense at the time tpct.

### [Embodiment]

As described above, in the operation circuit at the time of detection of a sudden voltage change 201 in the power supply device 1 according to the present embodiment, for example, it is possible to prevent a high voltage from being applied to a switching semiconductor element and the like by catching a steep change in voltage using the differentiation circuit 21 and performing protection using the short-circuit current protector 16 even at the time of a sudden voltage change.

In the operation circuit at the time of detection of a sudden voltage change 201 according to the present embodiment, for example, an operation of a switching power supply can be stopped quickly at the time of a sudden voltage change, and thereby it is possible to prevent a high voltage from being applied to a switching semiconductor element and the like in the main circuit 11.

Here, in the present embodiment, as overvoltage protection, two types of overvoltage protection are assumed. The first type of overvoltage protection is overvoltage protection when an overvoltage protection operation speed can be followed according to an overvoltage protection technology of the conventional example and a voltage rise speed is relatively slow. The input overvoltage protector 15 corresponds to a circuit of the overvoltage protection technology of the conventional example.

The second type of overvoltage protection is high-speed overvoltage protection when the overvoltage protection operation speed cannot be followed in the overvoltage protection technology of the conventional example, and the voltage rise speed is relatively steep.

The operation circuit at the time of detection of a sudden voltage change 201 corresponds to a circuit that realizes high-speed overvoltage protection. In the operation circuit at the time of detection of a sudden voltage change 201, a change speed (rise speed) of the voltage Vin_sense output from the input voltage detector 12 is detected by the differentiation circuit 21. Then, in the operation circuit at the time of detection of a sudden voltage change 201, the overvoltage protection at a high speed is realized by inputting a signal in accordance with a result of detection by the differentiation circuit 21 to the short-circuit current protector 16.

In this manner, in the present embodiment, normal input overvoltage protection and input voltage protection at the time of a sudden change are separately considered. Note that whether the voltage rise speed is slow or steep in an operation of the overvoltage protection is determined according to a time constant or the like set in a circuit.

In the present embodiment, the operation circuit at the time of detection of a sudden voltage change 201 realizes the overvoltage protection when a high-speed voltage change that cannot be followed in the input overvoltage protector 15 occurs.

In addition, in the operation circuit at the time of detection of a sudden voltage change 201 according to the present embodiment, as final overvoltage protection, an overcurrent protection circuit normally included in the power supply device 1 (a protection circuit related to the short-circuit current protector 16 in the present embodiment) is used and another protection circuit (for example, a protection circuit having a function of stopping switching) can also be used. For this reason, in the operation circuit at the time of detection of a sudden voltage change 201 according to the present embodiment, for example, even if a new protection circuit replacing these is not provided, it is possible to configure the protection circuits in parallel with a voltage level detection circuit.

Moreover, in the operation circuit at the time of detection of a sudden voltage change 201 according to the present embodiment, for example, it is possible to use a control component used in a general power supply circuit. As such a control component, for example, there are the comparator 71 and the reference power supply 72 that outputs the reference voltage Vref thereof.

Note that in the operation circuit at the time of detection of a sudden voltage change 201 according to the present embodiment, for example, there is no particular limitation on addition of a switch element, a position or presence or absence of the resistor 54, addition of another resistor, and the like, and various circuit configurations may be used.

Here, in the operation circuit at the time of detection of a sudden voltage change 201 according to the present embodiment, the comparator 71 is provided in the short-circuit current protector 16, but as another configuration example, a microcomputer or the like that performs digital processing for realizing similar processing may be used.

In addition, a configuration example in which an output voltage from the operation circuit at the time of detection of a sudden voltage change 201 is input to the short-circuit current protector 16 of a switching power supply is shown in the present embodiment, but the present invention is not limited thereto, and the output voltage may be input to various control systems. As a result, high-speed overvoltage protection can be performed in various control systems.

As another configuration, a configuration in which the output voltage from the operation circuit at the time of detection of a sudden voltage change 201 is input to a current detection circuit such as overcurrent protection including a function of protecting from a short-circuit current may be used.

As another configuration example, a configuration in which the output voltage from the operation circuit at the time of detection of a sudden voltage change 201 is input to a circuit (for example, a protection circuit) of a feedback system may also be used. As the circuit of the feedback system, for example, a circuit which follows a steep change of the input voltage Vin and performs control to stabilize an output voltage from the main circuit 11 may also be used. As the circuit of the feedback system, for example, a circuit which detects an error from a target value of the input voltage using an error amplifier and the like and performs control to adjust the duty ratio such that the error becomes small may also be used.

The operation circuit at the time of detection of a sudden voltage change 201 according to the present embodiment may be applied to an arbitrary circuit, and may be applied to, for example, not only a circuit that performs an operation on the basis of a change in input voltage to a target device, but also a circuit that performs an operation on the basis of a change in output voltage from the target device.

Moreover, the power supply device 1 according to the present embodiment may also be applied to an arbitrary device, and may also be applied to for example, a movable object such as an automobile.

### <Configuration example>

As a configuration example, the processing circuit (the operation circuit at the time of detection of a sudden voltage change 201 in the example of FIG. 1) includes a differentiation circuit (the differentiation circuit 21 in the example of FIG. 1) that outputs a differential value (Vder in the example of FIG. 1) of a change in a target voltage (the voltage Vin_sense in the example of FIG. 1), a predetermined voltage output unit (the predetermined voltage output unit 22 in the example of FIG. 1) that outputs a predetermined voltage (VDD in the example of FIG. 1) when a differential value output from the differentiation circuit is equal to or greater than a predetermined value (Vth1 in the example of FIG. 2), and a predetermined processing executor (the short-circuit current protector 16 in the example of FIG. 1) that executes predetermined processing on the basis of a voltage output from the predetermined voltage output unit to a protection circuit having a function of performing protection on the basis of a current detected by a current detector.

As one configuration example, in the processing circuit, predetermined processing performed by the predetermined processing executor includes processing of protecting from a short-circuit current.

As one configuration example, in the processing circuit, the predetermined processing performed by the predetermined processing executor includes processing of protecting from an overcurrent.

As one configuration, in the processing circuit, the predetermined processing performed by the predetermined processing executor includes processing of a feedback system.

As one configuration, in the processing circuit, the predetermined processing performed by the predetermined processing executor includes processing of following a change of the target voltage and performing control to stabilize an output voltage from a main circuit which supplies a power to a load.

As one configuration, in the processing circuit, the predetermined processing performed by the predetermined processing executor includes processing of detecting an error from a target value of the target voltage and performing control to adjust the duty ratio such that the error becomes small.

As one configuration, a power supply device includes the processing circuit as described above.

### [Embodiments above]

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

### EXPLANATION OF REFERENCES

1 Power supply device
11 Main circuit
12 Input voltage detector
13 Current detector
14 Sudden voltage change detector
15 Input overvoltage protector
16 Short-circuit current protector
21 Differentiation circuit
22 Predetermined voltage output unit
31 Input power supply
32 Load
33 Input capacitor
51 Auxiliary power supply
52, 53 Switch
54, 62 Resistor
61 Capacitor
71 Comparator
72 Reference power supply
111 to 116 Ground end
201 Operation circuit at time of detection of sudden voltage change
211, 212 Connecting line
231, 232, 421, 422 Input terminal
233, 411, 412, 423, 424, 433, 434 Output terminal
311 to 313 Waveform
431 Inflow terminal
432 Outflow terminal
441, 442 Terminal

## Claims

1. A processing circuit comprising:
a differentiation circuit configured to output a differential value of a change in a target voltage;
a predetermined voltage output unit configured to output a predetermined voltage when the differential value output from the differentiation circuit is equal to or greater than a predetermined value; and
a predetermined processing executor configured to execute predetermined processing based on a voltage output from the predetermined voltage output unit on a protection circuit having a function of performing protection on a basis of a current detected by a current detector.

2. The processing circuit according to claim 1,
wherein the predetermined processing performed by the predetermined processing executor includes processing of protecting from a short-circuit current.

3. The processing circuit according to claim 1,
wherein the predetermined processing performed by the predetermined processing executor includes processing of protecting from an overcurrent.

4. The processing circuit according to claim 1,
wherein the predetermined processing performed by the predetermined processing executor includes processing of a feedback system.

5. The processing circuit according to claim 4,
wherein the predetermined processing performed by the predetermined processing executor includes processing of following a change of the target voltage and performing control to stabilize an output voltage from a main circuit which supplies a power to a load.

6. The processing circuit according to claim 4,
wherein the predetermined processing performed by the predetermined processing executor includes processing of detecting an error from a target value of the target voltage and performing control to adjust the duty ratio such that the error becomes small.

7. A power supply device comprising:
the processing circuit described in any one of claims 1 to 6.
